(19) Europäisches Patentamt
European Patent Office
Office européen des brevets

(11) **EP 1 950 887 A1**

(12) **EUROPEAN PATENT APPLICATION**

(43) Date of publication:
**30.07.2008 Bulletin 2008/31**

(51) Int Cl.:
***H03M 13/11*** *(2006.01)*

(21) Application number: **07001428.7**

(22) Date of filing: **23.01.2007**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicant: **Nokia Siemens Networks GmbH & Co. KG**
**81541 München (DE)**

(72) Inventors:
• **Lampe, Mattias**
**100102 chaoyang district, Beijing (CN)**

• **Ni, Jun Feng**
**800 Dongchuan Lu**
**200240 Shangai (CN)**
• **Weng, Zhi Cheng**
**800 Dongchuan Lu**
**200240 Shangai (CN)**
• **Zang, Haibain**
**200030 Shangai (CN)**
• **Zhu, Jian**
**200030 Shangai (CN)**

(54) **Code design and hardware architecture for high throughput LDPC decoder**

(57) A decoder device is configured to use a low-density parity-check coding scheme. The decoder device comprises a top layer unit configured to calculate bit node messages, and a bottom layer unit configured to calculate check node messages. The bottom layer unit further comprises a shuffle network unit configured to transmit data from the top layer unit to the bottom layer unit and vice versa, and to re-order data in the bottom layer unit.

## FIG 4

**Description**

Field of the Invention

The present invention relates to a device and method for performing a low-density parity-check (LDPC) coding with high throughput.

Related Background Art

Low-density parity-check (LDPC) codes were first introduced by Gallagher in his thesis in 1961 (see e.g. Robert C. Gallagher: "Low-density parity-check codes", The M.I.T. Press, Cambridge, Mass., 1963, Chapter 2). For its good performance and wide application in nearly all channels, LDPC codes have already become one of the hottest topics on the filed of channel encoding. Along with the development of LDPC codes technology, there appear many implementation schemes. Recently, the decoder design for LDPC codes has become one of the most interesting issues for researchers. Thus, how to design a simple and efficient decoder and the interrelated LDPC codes is an important problem.

Totally, there are two kinds of LDPC codes, a regular code and an irregular code. On the assumption that an H matrix is an mxn matrix, the regular LDPC code can be denoted as (n, j, k), where n is the block length, j is the column weight, k is the row weight, and usually there exists j≥2, k>j. The column weight and row weight of irregular LDPC codes are variable for different columns and rows.

The technical challenge with LDPC codes lies in the efficient implementation of the coder and decoder and in the design of codes that support such particularly efficient (in terms of speed, resource consumption, etc.) and yet powerful (in terms of bit error performance) implementations.

For a variety of communication standards currently under development (e.g. 802.11n, 802.15, 3GPlus), Low-Density Parity Check (LDPC) codes have been suggested as an option for the Forward Error Correction (FEC) scheme.

Up to now, there are mainly three types of structures of LDPC decoder. They are a serial structure, a full parallel structure and a partial parallel structure. They all have their own advantages and disadvantages. The full parallel structure can achieve a very high throughput, usually at the level of several gigabits per second, but costs too much hardware resources. Among them, the serial structure costs the least resources but achieves the lowest throughput. Partial parallel structure makes a compromise between the parallel and the serial structure, and obtains a good tradeoff between throughput and complexity.

Decoder implementations are usually based on the Belief Propagation algorithm or variants thereof.

One of the most important LDPC decoding methods is based on the BP (Belief Propagation) algorithm, which is a typical iterative decoding algorithm, also named as SPA (Sum Product Algorithm). Generally, irregular LDPC codes have a better performance than regular ones, but the former bears much more complexity in hardware implementation. The steps of the LDPC decoding are listed below.

Denotations:

| | |
|---|---|
| $Q_{ij}$ | messages to be passed from bit node $c_i$ to check nodes $f_j$; |
| $R_{ji}$ | messages to be passed from check node $f_j$ to bit node $c_i$; |
| $R_j = \{j: h_{ji} = 1\}$ | the set of column locations of the 1's in the jth row; |
| $R_{j\backslash i} = \{i' : h_{ji'} = 1\} \backslash \{i\}$ | the set of column locations of the 1's in the jth row, excluding location i; |
| $C_i = \{j: h_{ji} = 1\}$ | the set of row locations of the 1's in the ith column; |
| $C_{i\backslash j} = \{j' : h_{j'i} = 1\} \backslash \{j\}$ | the set of row locations of the 1's in the ith column, excluding location j; |
| LLR | soft value received from the channel. |

Algorithm:

(1) Initialization:

$$Q_{ij} = LLR_i \qquad\qquad (1.1)$$

(2) Check node messages update:

$$R_{ji} = \prod_{i' \in R_{Nj}} \alpha_{i'j} \phi \left[ \sum_{i' \in R_{Nj}} \phi\left(\beta_{i'j}\right) \right] \qquad (1.2)$$

(3) Bit node messages update:

$$Q_{ij} = C_i + \sum_{j' \in C_{Nj}} r_{j'i} \qquad (1.3)$$

(4) Soft message calculation:

$$Q_i = C_i + \sum_{j \in C_i} r_{ji} \qquad (1.4)$$

(5) Hard decision:

$$\hat{c}_i = \begin{cases} 1 & if \ Q_i < 0 \\ 0 & elsewhere \end{cases} \qquad (1.5)$$

If $\hat{c} H^T = 0$ or the number of iteration exceeds the limitation, then stop, else go to step 2.

A simplified version of the BP algorithm, the so-called minsum (MS) algorithm, reduces the computational complexity by eliminating the look-up table (LUT) for the

$$\text{function } \phi(x) = \log \frac{e^x + 1}{e^x - 1} .$$

However, the MS algorithm is 0.5 to 1 dB worse in Bit Error Correction (BER) than BP algorithm, which makes it necessary to add a modification to MS algorithm for compensation. Specifically, such a modification may be an algorithm which scales the reliability of check node result by a factor between 0 and 1, and thus can achieve a similar decoding performance to BP algorithm. In the following, this is designated by "modified MS algorithm".

Apart from a simplification of the BP algorithm, it also has been discussed how to improve the performance of BP algorithm. Namely, a layered BP algorithm has been introduced which achieves a similar performance to BP algorithm with only half iteration times, because updated information of layer iteration is utilized more quickly. Here, in each layer of a parity check matrix, there should be no more than one '1' in each column.

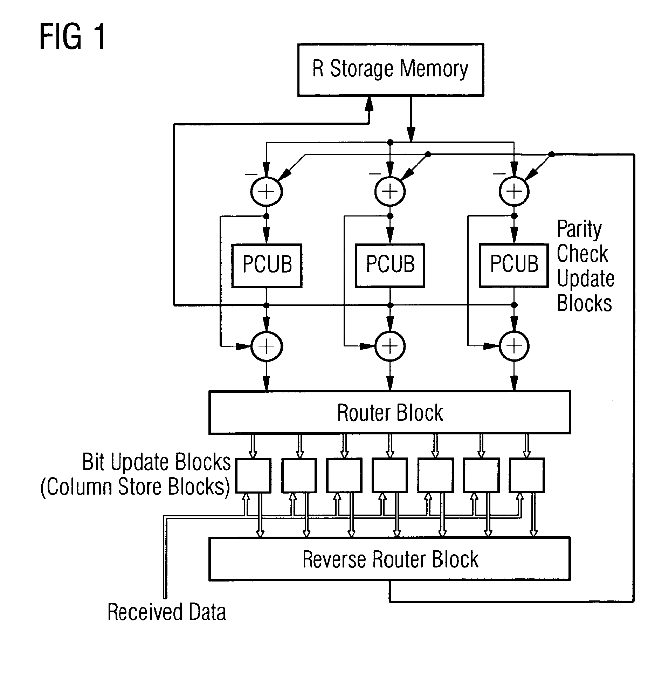

In other words, BP decoder decodes like a parallel concatenated decoder, while a layered BP decoder behaves like a serial concatenated decoder. In the article of Dale E. Hocevar: "A reduced complexity decoder architecture via layered decoding of LDPC codes", Signal Processing Systems, 2004, a layered BP decoder architecture has been advanced the top architecture of which is shown in Fig. 1 (with a vector/parallel factor of three).

Summary of the Invention

It is an object of the present invention to provide a device and method for performing a low-density parity-check with high throughput and at low costs regarding the hardware complexity.

According to a first aspect of the present invention, this is accomplished by a decoder device for use with a low-density parity-check coding scheme, comprising a top layer unit configured to calculate bit node messages; and a bottom layer unit configured to calculate check node messages, the bottom layer unit further comprising a shuffle network unit configured to transmit data from the top layer unit to the bottom layer unit and vice versa, and to re-order data in the bottom layer unit.

Modifications of this first aspect may include the following.

The top layer unit may comprise a plurality of top layer unit elements configured to operate independently from each other, and the bottom layer unit may comprise a plurality of bottom layer unit elements configured to operate in parallel to each other.

The number of the bottom layer unit elements may be a parallelization factor k, and the number of top layer unit elements may be equal to k.

The shuffle network unit may comprise $\log_2 k$ shuffle network layers with a shuffle network layer being defined vertically to an input/output-direction and in turn comprising k/2 cross $2\times2$ elements so that in a first shuffle network layer, each cross $2\times2$ element comprises two inputs, in a last shuffle network layer, each cross $2\times2$ element comprises two outputs, and in any shuffle network layer in-between, each cross $2\times2$ element is connected with two different cross $2\times2$ elements of a preceding shuffle network layer at its input side and with two different cross $2\times2$ elements of a succeeding shuffle network layer at its output side.

The bottom layer unit may be further configured to select all the cross $2\times2$ elements such that an identity between input and output of the shuffle network unit is cyclically shifted.

According to a second aspect of the present invention, the object is solved by a method of using a low-density parity-check coding scheme, comprising calculating bit node messages by using a top layer unit of a decoder device; calculating check node messages by using a bottom layer unit of the decoder device; transmitting data from the top layer unit to the bottom layer unit and vice versa by using a shuffle network unit comprised in the bottom layer unit; and re-ordering data by using the shuffle network unit.

Modifications of this second aspect may include the following.

The step of calculating bit node messages may comprise using a plurality of top layer unit elements and the step of calculating check node messages may comprise using a plurality of bottom layer unit elements, wherein the method may further comprise operating the plurality of top layer unit elements independently from each other; and operating the plurality of bottom layer unit elements in parallel to each other.

The number of the bottom layer unit elements may be a parallelization factor k, and the number of top layer unit elements may be equal to k.

The step of transmitting data may comprise using $\log_2 k$ shuffle network layers within the shuffle network unit with a shuffle network layer being defined vertically to an input/output-direction and in turn using k/2 cross $2\times2$ elements wherein in a first shuffle network layer, each cross $2\times2$ element uses two inputs, in a last shuffle network layer, each cross $2\times2$ element uses two outputs, and in any shuffle network layer in-between, each cross $2\times2$ element connects with two different cross $2\times2$ elements of a preceding shuffle network layer at its input side and with two different cross $2\times2$ elements of a succeeding shuffle network layer at its output side.

The method may further comprise selecting all the cross $2\times2$ elements by the bottom layer unit such that an identity between input and output of the shuffle network unit is cyclically shifted.

Brief Description of the Drawings

Further details and aspects as well as advantages of the present invention will become apparent from the following detailed description of its preferred embodiments which is to be taken in conjunction with the appended drawings, in which:

Fig. 1 shows a top level architecture of a LDPC decoder using layered mode belief propagation;

Fig. 2 shows an H matrix structure overview according to a preferred embodiment of the present invention;

Fig. 3 shows a sub-matrix structure according to the H matrix structure overview of Fig. 2;

Fig. 4 shows a decoder architecture overview according to another preferred embodiment of the present invention;

Fig. 5 shows a code division for illustrating the presence of a plurality of top layer in Fig. 4;

Fig. 6 shows a detailed view of a top layer according to still another preferred embodiment of the present invention;

Fig. 7 shows a detailed view of a shuffle and bottom layer according to still another preferred embodiment of the present invention;

Fig. 8 shows a cyclic-shift identity matrix whose expansion factor is 48 for illustrating the use of shuffle network in bottom layer according to still another preferred embodiment; and

Fig. 9 shows a shuffle network architecture according to still another preferred embodiment of the present invention.

Detailed Description of preferred Embodiments

What is described herein below is a detailed description of what is presently considered as the preferred embodiments of the present invention. It is, however, to be understood that this description is provided only for illustrative purposes and to present further implementation examples for enabling to carry out the present invention, but is by no means intended to restrict the present invention to the disclosed details.

In the following, one kind of partial parallel structure of a flexible low-density parity-check (LDPC) decoder based on a layered modified min-sum (LMMS) decoding algorithm is described. It will be demonstrated that this decoder always works at full speed for all code lengths and code rates with a constant throughput. For illustrative purposes, the architecture for regular codes is described, but in knowledge thereof, it should be apparent to the skilled person that the architecture can be revised to support irregular codes with limited effort, which thus shall be included in the present preferred embodiments of the present invention.

Specifically, hereinafter a flexible LDPC decoder using a layered modified min-sum (LMMS) decoding algorithm for a duplex expansion (DEx) regular LDPC code is described. With this new decoder, a high throughput at low costs of hardware complexity can be achieved. Moreover, this decoder always works at full speed for all code lengths and code rates with a constant throughput.

The LMMS algorithm can be described as follows:

(1) Initialization:

$$L(Q_i^{(0)}) = y_i \qquad (2.1)$$

(2) Bit node update (i):

$$L(q_{ijm}^{(n)}) = L(Q_{im}^{(n-1)}) - L(r_{ijm}^{(n-1)}) \qquad (2.2)$$

(3) Check node update:

$$L\left(r_{ijm}^{(n)}\right) = \prod_{i' \in R_{j\setminus i}} sign\left(L\left(q_{i'jm}^{(n)}\right)\right) \cdot \min_{i' \in R_{j\setminus i}}\left(\left|L(q_{i'jm}^{(n)})\right|\right) \cdot k, \quad \text{where } k=0.8 \qquad (2.3)$$

(4) Bit node update (ii) :

$$L(Q_{im}^{(n)}) = L(r_{ijm}^{(n)}) + L(q_{ijm}^{(n)}) \qquad (2.4)$$

(5) Terminate if the hard decision is correct, otherwise $m=m+1$; if $m$ exceeds the number of layers in the parity check matrix, then $n=n+1$ and $m=1$;

(6) Terminate if $n$ exceeds the maximum number of iteration, otherwise go to step (2).

$y_i$ is the received symbol for variable $i$. Since MS algorithm only cares about the relative magnitude of the variable node logarithmic likelihood rate (LLR), a received symbol can be directly used for decoding. $L(q_{ijm}^{(n)})$ is LLR of variable $i$ after $n$ matrix iterations and $m$ layer iterations. $L(Q_{im}^{(n)})$ is a posteriori LLR of variable $i$ after $n$ matrix iterations and $m$ layer iterations. $L(r_{ijm}^{(n)})$ is LLR of variable $i$ after $j$-th check node calculation, $n$ matrix iterations and $m$ layer iterations.

The LMMS algorithm is a combination of the Layered Belief Propagation algorithm and the Min Sum algorithm. According to an embodiment of the present invention, it is proposed to use this new algorithm in connection with a practical implementation which is described later on.

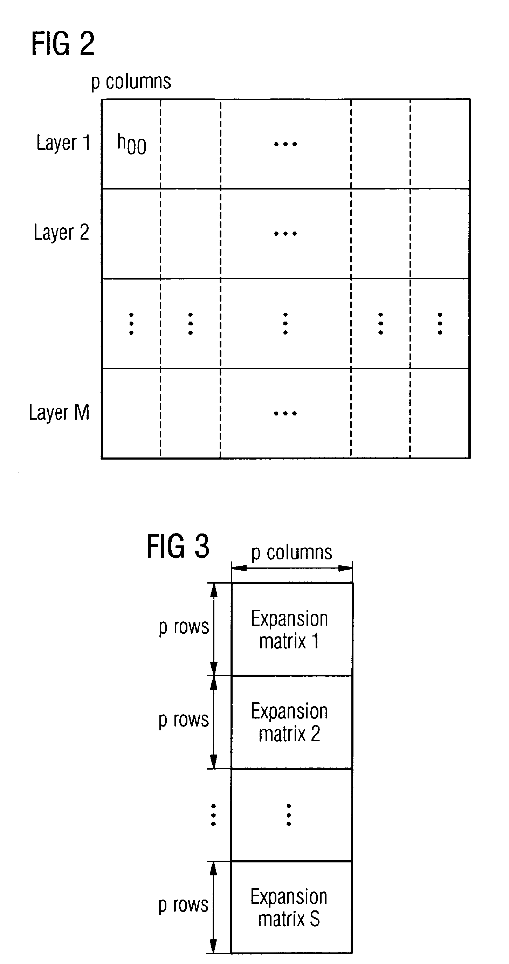

Fig. 2 shows a structure overview of an H matrix which can be applied in the decoder of the present embodiment. It shall be supposed the expansion factor is p, and the parallelization factor is k, wherein the expansion factor of the code should be a multiple of the parallelization factor of the decoder. The H matrix has these features as follows:

(1) If the column weight of the code word is m, the H matrix can be divided into m layers. Each layer has the same number of rows and the column weight of each layer is 1.

(2) Each layer is divided into several units in column direction and each unit has p columns, as shown in Fig. 2. This kind of unit is called sub-matrix, and h00 indicates one example of such sub-matrices.

(3) Fig. 3 shows the structure of the sub-matrix, which is divided into several expansion matrices in row direction. Each pxp expansion matrix is a cyclic-shift identity matrix or a matrix whose elements are totally zero. In the picture, S = (the number of rows) / (the number of layers) / (expansion factor).

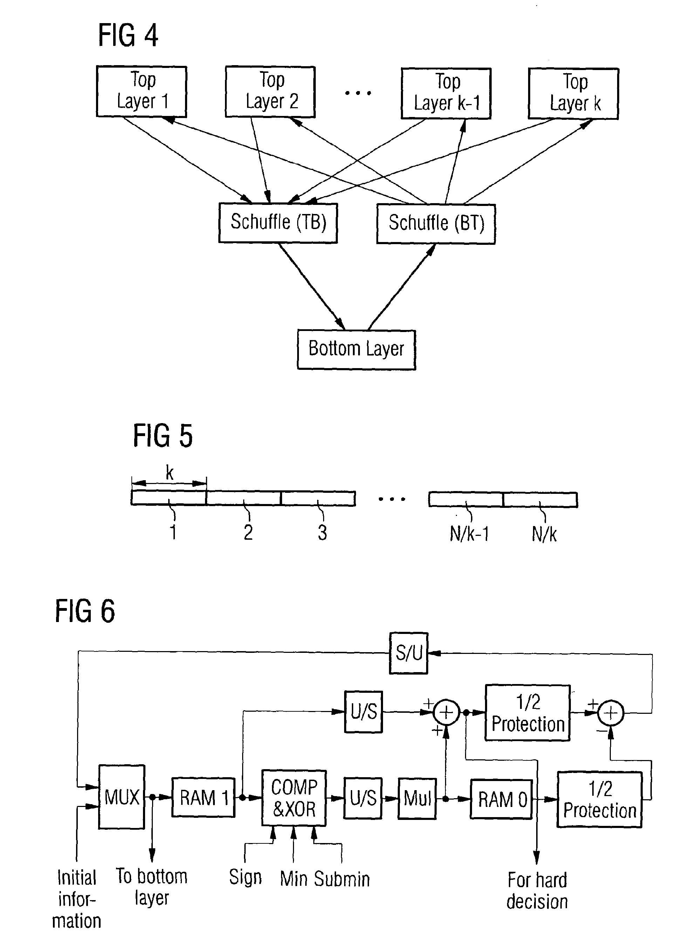

As shown in Fig. 4, the decoder is divided into two parts. The top layer is mainly used to calculate the bit node messages and the main function of the bottom layer is to calculate the check node messages. The two parts transmit the data to each other by shuffles. It is to be noted that every shuffle may be combined by many smaller shuffles (for one bit).

The number of the top layers is decided by the parallelization factor. When the parallelization factor is set to k, there will be k top layers and the code (length is N) is divided into N/k parts. The decoder will read in k consecutive LLR per clock cycle and the ith LLR will enter the ith top layer, as show in Fig. 5.

Fig. 6 shows a detailed view of a top layer according to a preferred embodiment of the present invention.

In the following, a mode of operation according to the instant embodiment is described.

When the input enable signal comes, the k top layers begin working as follows.

(1) The data is read from the RAM1 which stores the LLR, simultaneously the bottom layer modules output Sign, Min and Sub-min;

(2) The 'COMP&XOR' module works in the following way: If LLR from RAM1 equals the minimal LLR, the result is the sub-minimal LLR. Else, the result is the minimal LLR. Further, the result of the Sign equals the Sign from bottom layer XOR to the Sign from RAM1;

(3) The 'U/S' module transforms the unsigned data to a signed data;

(4) The 'MUL' module is a multiplicative computational unit which fulfills the compensation in modified MS algorithm. A different multiplicative factor causes different resource consumption;

(5) The first adder does the computation of equation (3.4) and outputs an *a posteriori* LLR $L(Q_{im}^{(n)})$. RAM0 stores $L(r_{ijm}^{(n)})$ and outputs $L(r_{ij(m+1)}^{(n-1)})$ during one iteration. The second adder does the computation of equation (3.2) and outputs $L(q_{ij(m+1)}^{(n)})$, and then the 'S/U' module transforms the signed data to an unsigned data;

(6) After that, the unsigned data enters the 'MUX' module. If it is the first iteration, the 'MUX' will deliver the initial LLR to the bottom-layer module, and simultaneously store the result into the RAM1. Else, the delivered data will be the LLR after iteration;

(7) When the computation of k columns ends, return to step (1) to start the next k columns computation; and

(8) When the computation of all the columns ends, wait for the next input enable signal.

It is to be noted that each iteration starts from step (1), not step (6). Further, since the addressing for RAM1 in k top layers is the same, these k blocks of RAM can be merged so that a block RAM in a field programmable gate array (FPGA) is utilized more efficiently. So does RAM0 in k top layers.

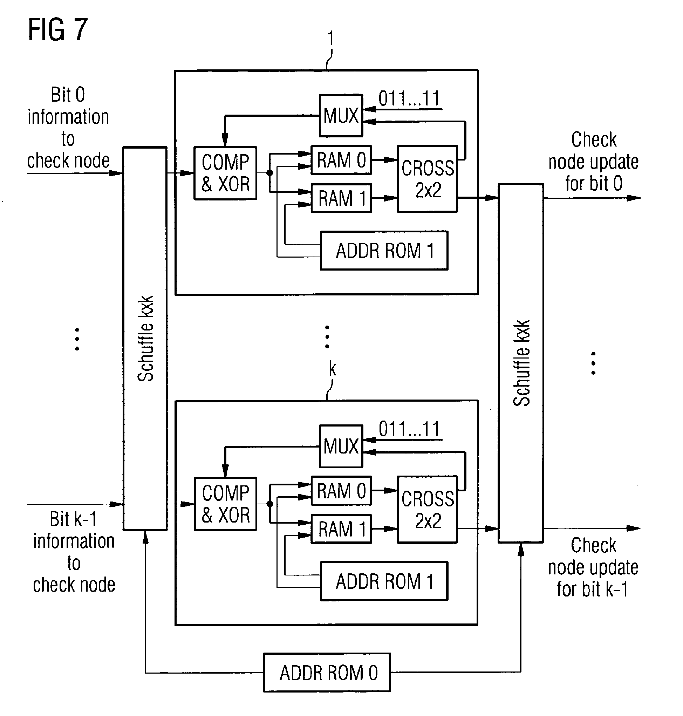

Fig. 7 shows a detailed view of a shuffle and bottom layer according to a preferred embodiment of the present invention.

In the following, a mode of operation according to the instant embodiment is described.

When the input enable signal comes, the bottom layers begin working.

(1) The addresses of the ping-pong RAM are generated by reading the 'ADDR ROM1';

(2) Read RowSum(1) (Sign1, Min1 and Sub-min1), ..., RowSum(k) from one of the ping-pong RAM, and output them to the 'Shuffle' module;

(3) Through the 'Shuffle' module, re-order the messages of RowSum(1), ..., RowSum(k), then output them to the Top-Layers. The mode selection is generated by reading the 'ADDR ROM0';

(4) Through the structure in Fig. 6, after several clocks, the k top layers can output the data required by this bottom-layer module, and the 'shuffle' module gets the data;

(5) The shuffle whose mode selection is generated by reading the 'ADDR ROM0' re-orders the data. Then, they are output to the 'COMP&XOR' modules (There are k modules).

(6) There are two sources of MUX. If it is the first iteration, MUX chooses the '011...11'. Else MUX will choose the data from the other ping-pong RAM (Not the one used in step (2)).

(7) The 'COMP&XOR' module outputs the Sign, Min and Sub-min and they will be stored into the other ping-pong RAM (The same one of step (6)). The 'COMP&XOR' module works as follows: The result of the Sign equals the Sign from shuffle XOR to the Sign from MUX. If the data from shuffle is smaller than the Min from MUX, the Min is the data from shuffle and the Sub-min becomes the Min from MUX. If the data from shuffle is smaller than the Sub-min from MUX and bigger than the Min from MUX, the Min will be the Min from MUX and the Sub-min becomes the data from shuffle. Else, the Min and Sub-min will be the ones from MUX.

(8) When this process ends, return to step (1) to start the next process;

(9) When all the rows in this bottom-layer module are updated, stop and wait for the next input enable signal. Simultaneously change the selection of 'Cross2x2' module to let the two blocks of ping-pong RAM exchange.

According to a preferred embodiment of the present invention, a shuffle network instead of a conventionally used crossbar is adopted to re-order the data in bottom layer.

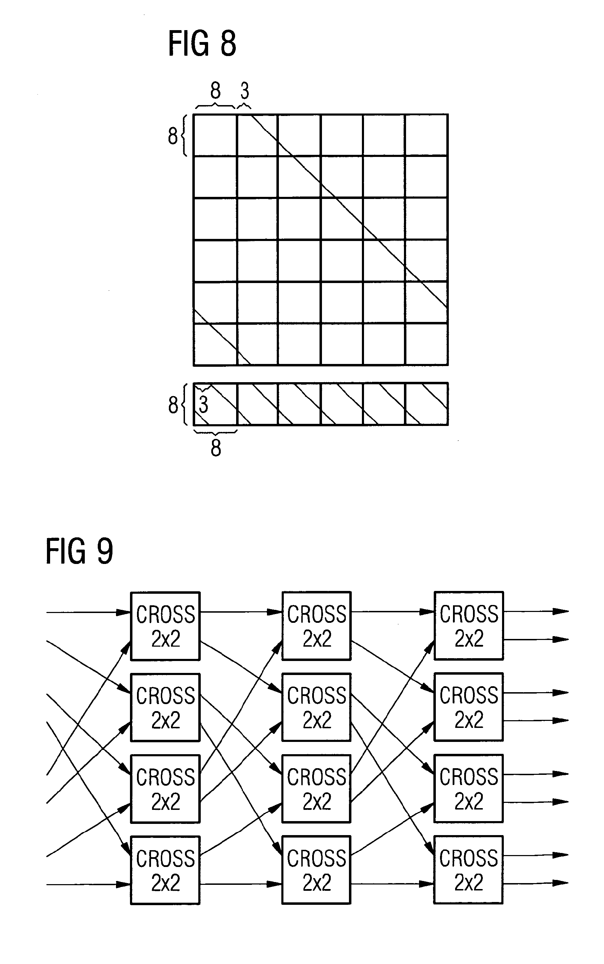

Fig. 8 shows a 48x48 cyclic-shift identity matrix generated by expansion. Since the parallelization factor is 8, the decoder reads in 8 variable LLR per clock cycle so that this 48x48 cyclic-shift identity matrix can be regarded as a compact 8x48 matrix, which is composed of 6 identical 8x8 cyclic-shift identity matrices. Therefore, the shuffle network just needs to cyclically shift the input into their corresponding rows. For instance, with respect to Fig. 8, the 4th input (indicated by a diagonal line next to the indication '3' on the top side of the matrix) should be shifted into the 1st output (indicated by the diagonal line crossing the top line) and the 5th input to the 2nd output and so on. As the shift factor may change from 0 to 7, the shuffle network should support all these 8 situations (see table 1):

**Table 1: Map table for input and output of shuffle network**

| Input | | Output | | | |
|---|---|---|---|---|---|
| 1 | | 1 | 8 | ... | 2 |
| 2 | | 2 | 1 | ... | 3 |
| 3 | | 3 | 2 | ... | 4 |
| ... | | ... | ... | ... | ... |
| 8 | | 8 | 7 | ... | 1 |

Fig. 9 shows an example for a shuffle network architecture according to a preferred embodiment of the present invention. As shown in Fig. 9, if the input is k, the shuffle network has $\log_2 k$ layers and there are k/2 CROSS2x2 units (k MUX units) in each layer. That is, as shown in Fig. 9, by referring again to the example k = 8, $\log_2(8) = 3$ so that three layers are depicted (extending vertically to an input/output direction). Accordingly, there are k/2 = 4 cross 2x2 units in each layer shown.

In comparison, if crossbar would have been utilized for this exchanging network, kx(k-1) MUX units would have been needed, where k equals the input number. Here, the shuffle network structure is taken from router for realization,

only with kxlog$_2$k MUX units.

It is to be noted that the selections of all the CROSS2x2 units are generated by reading from 'ADDR ROM0' (see Fig. 7), and there are k situations so the depth of 'ADDR ROM0' is k. Further, the address of 'ADDR ROM0' is dependent on the shift factor of the cyclic-shift identity matrix by being expanded.

According to preferred embodiments of the present invention, the logical modules in top and bottom layers work at full speed.

Specifically, the working efficiency is important to assess a decoder. From the above analysis, it can be seen that logical modules in the decoder always work at full speed, while the efficiency of block RAM may differ slightly for different code lengths.

In the present design, the code is divided into n/k units (n is the length of code, while k is the parallel factor) for the partial parallel structure. For each clock, k values (responding to one unit) enter the bottom layer, simultaneously the k bottom-layer modules output Sign, Min and Sub-min (respond to another unit), and they are dealt with by the top layers. So the top layer and bottom layer are working simultaneously and there is no need for top or bottom layers to wait.

Moreover, preferred embodiments of the present invention are also capable of dealing with hardware bugs of RAM in the bottom layer.

That is, in the bottom layer, RAM0 and RAM1 of ping-pong RAM store Sign and two LLR, namely, minimal and sub-minimal LLR in every row. In view of a FPGA implementation, block RAM is mostly configured to have two pipeline delays, which makes two consecutive '1' in the same row in parent matrix, i.e. '1 1', and another mode '1 0 1' illegal.

In order to solve this problem, the decoding sequence is re-ordered to avoid the above two conditions. The method is that in H matrix, if one kxk matrix appears which is not a zero matrix, the following two matrices should be exchanged to zero matrices. Then, the decoding sequence will be re-ordered according to the new H matrix.

Besides, preferred embodiments of the present invention are also capable of dealing with the overflow of LLR.

In detail, in the top layer, the purpose of '1/2 PROTECTION' module is to prevent the LLR from becoming too large. If the data width of LLR is 7, the maximum value of LLR will be 63. But it can be seen that the value of LLR becomes very large when the number of iteration increases. So when the LLR become large and are going to be overflowed, the '1/2 PROTECTION' module will divide all the value of $L(r_{ijm}^{(n)}), L(q_{ijm}^{(n)})$ by 2. In this way, the decoder will work normally.

Preferred embodiments of the present invention can gain the following advantages.

The suggested design is an LDPC decoder with flexibility in code length and code rate as well as high throughput and low complexity. Besides, working efficiency is another factor to assess a decoder. A good design should make all the circuits working at full speed for different kinds of code length and code rate. From the above analysis, it can be seen that logical modules in the decoder always work at full speed, while the efficiency of block RAM may differ slightly for different code lengths. If the code length is the same, no matter what the code rate is, the block RAM efficiency is unchanged. But when the code length is different, the efficiency of block RAM will be decided by the biggest code length. As a whole, the efficiency of this decoder for different code length and code rate is quite satisfying.

Because using the layered structure, the decoding performance is improved by about two times in the number of iterations required for a given error rate. In addition, there is a significant reduction in the number of required memory bits and memory instances, in the range of 45-50%. Furthermore, the faster decoding speed means that the decoder logic can also be reduced by nearly 50% to achieve the same throughput and error performance. In total, the overall decoder architecture can be reduced by nearly 50%.

The result of an example using the decoder architecture according to preferred embodiments of the present invention is given. The total resource consumption is shown in Table 2 and the throughput of the decoder is shown in Table 3.

**Table 2: Resource consumption in all**

| | Slice | Block Ram | Remark |
|---|---|---|---|
| **Total** | 57% | 83% | Based on Xilinx Virtex-II v6000 (Trademark of Xilinx, Inc.) |

**Table 3: Throughput for various code parameters**

| Code type | (2304,1152) | (1152,576) | (2304,576) | (1152,288) |
|---|---|---|---|---|
| **Total Throughput (Mbps)** | 219 (73*3) | 192 (64*3) | 219 (73*3) | 192 (64*3) |

The following is to be noted:

(1) The code length will affect the throughput.

The explanation is that the time T (number of clocks) taken in one iteration contains two parts: the processing time (Tp) and the delay (Td). That is, T = Tp + Td. Tp is decided by the length of the code and the parallel. That is, Tp = block length/parallel, wherein Td is a fixed delay. In the present design, it is about 12 clocks. So the shorter the block length is, the more percentage Td will take in time T. Hence, the throughput of one high parallel decoder will be lower than several low parallel decoders with the same resource usage.

(2) Some of the slices are used as distributed RAMs, because the Block RAM resource is limited.

Thus, described above are preferred embodiments of the present invention which include a decoder device that is configured to use a low-density parity-check coding scheme. The decoder device comprises a top layer unit configured to calculate bit node messages, and a bottom layer unit configured to calculate check node messages. The bottom layer unit further comprises a shuffle network unit configured to transmit data from the top layer unit to the bottom layer unit and vice versa, and to re-order data in the bottom layer unit.

While it has been described above what is presently considered to be preferred embodiments of the present invention, as is apparent to the skilled reader, these are however provided for illustrative purposes only and are in no way intended that the present invention is restricted thereto. Rather, it is the intention that all variations and modifications be included which fall within the scope of the appended claims.

**Claims**

1. A decoder device for use with a low-density parity-check coding scheme, comprising
   a top layer unit configured to calculate bit node messages; and
   a bottom layer unit configured to calculate check node messages, the bottom layer unit further comprising
   a shuffle network unit configured to transmit data from the top layer unit to the bottom layer unit and vice versa, and to re-order data in the bottom layer unit.

2. The device according to claim 1, wherein the top layer unit comprises a plurality of top layer unit elements configured to operate independently from each other, and the bottom layer unit comprises a plurality of bottom layer unit elements configured to operate in parallel to each other.

3. The device according to claim 2, wherein the number of the bottom layer unit elements shall be a parallelization factor k, and the number of top layer unit elements is equal to k.

4. The device according to claim 3, wherein the shuffle network unit comprises $\log_2 k$ shuffle network layers with a shuffle network layer being defined vertically to an input/output-direction and in turn comprising k/2 cross $2\times2$ elements so that in a first shuffle network layer, each cross $2\times2$ element comprises two inputs, in a last shuffle network layer, each cross $2\times2$ element comprises two outputs, and in any shuffle network layer in-between, each cross $2\times2$ element is connected with two different cross $2\times2$ elements of a preceding shuffle network layer at its input side and with two different cross $2\times2$ elements of a succeeding shuffle network layer at its output side.

5. The device according to claim 4, wherein the bottom layer unit is further configured to select all the cross $2\times2$ elements such that an identity between input and output of the shuffle network unit is cyclically shifted.

6. A method of using a low-density parity-check coding scheme, comprising
   calculating bit node messages by using a top layer unit of a decoder device;
   calculating check node messages by using a bottom layer unit of the decoder device;
   transmitting data from the top layer unit to the bottom layer unit and vice versa by using a shuffle network unit comprised in the bottom layer unit; and
   re-ordering data by using the shuffle network unit.

7. The method according to claim 6, wherein the step of calculating bit node messages comprises using a plurality of top layer unit elements and the step of calculating check node messages comprises using a plurality of bottom layer unit elements, the method further comprising
   operating the plurality of top layer unit elements independently from each other; and
   operating the plurality of bottom layer unit elements in parallel to each other.

8. The method according to claim 7, wherein the number of the bottom layer unit elements shall be a parallelization factor k, and the number of top layer unit elements is equal to k.

9. The method according to claim 8, wherein the step of transmitting data comprises using $\log_2 k$ shuffle network layers within the shuffle network unit with a shuffle network layer being defined vertically to an input/output-direction and in turn using k/2 cross 2×2 elements wherein in a first shuffle network layer, each cross 2×2 element uses two inputs, in a last shuffle network layer, each cross 2×2 element uses two outputs, and in any shuffle network layer in-between, each cross 2×2 element connects with two different cross 2×2 elements of a preceding shuffle network layer at its input side and with two different cross 2×2 elements of a succeeding shuffle network layer at its output side.

10. The method according to claim 9, further comprising
selecting all the cross 2×2 elements by the bottom layer unit such that an identity between input and output of the shuffle network unit is cyclically shifted.

# FIG 1

## FIG 2

p columns

| | $h_{00}$ | | $\cdots$ | | |
| --- | --- | --- | --- | --- | --- |
| Layer 1 | | | | | |
| Layer 2 | | | $\cdots$ | | |
| | $\vdots$ | $\vdots$ | $\vdots$ | $\vdots$ | $\vdots$ |
| Layer M | | | $\cdots$ | | |

## FIG 3

p columns

| | |
| --- | --- |
| p rows | Expansion matrix 1 |
| p rows | Expansion matrix 2 |
| $\vdots$ | $\vdots$ |
| p rows | Expansion matrix S |

## FIG 4

## FIG 5

## FIG 6

# FIG 7

Bit 0
information
to
check node

Schuffle kxk

MUX   011...11

COMP
& XOR

RAM 0

RAM 1

CROSS
2x2

ADDR ROM 1

Check
node update
for bit 0

Bit k-1
information
to
check node

k

MUX   011...11

COMP
& XOR

RAM 0

RAM 1

CROSS
2x2

ADDR ROM 1

Schuffle kxk

Check
node update
for bit k-1

ADDR ROM 0

FIG 8

FIG 9

European Patent
Office

**EUROPEAN SEARCH REPORT**

Application Number

EP 07 00 1428

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GUILLOUD F: "Architecture générique de décodeur de codes LDPC" THÈSE PRÉSENTÉE POUR OBTENIR LE GRADE DE DOCTEUR DE L'ÉCOLE NATIONALE SUPÉRIEURE DES TÉLÉCOMMUNICATIONS, XX, XX, 2 July 2004 (2004-07-02), page complete, XP002370625 * page 44; figure 3.1 * ----- | 1,2 | INV. H03M13/11 |
| X | LECHNER G ET AL: "Implementation of an LDPC decoder on a vector signal processor" SIGNALS, SYSTEMS AND COMPUTERS, 2004. CONFERENCE RECORD OF THE THIRTY-EIGHTH ASILOMAR CONFERENCE ON PACIFIC GROVE, CA, USA NOV. 7-10, 2004, PISCATAWAY, NJ, USA,IEEE, 7 November 2004 (2004-11-07), pages 549-553, XP010780361 ISBN: 0-7803-8622-1 * the whole document * * figure 3 * ----- | 1 | |
| A | YEO E ET AL: "High throughput low-density parity-check decoder architectures" GLOBECOM'01. 2001 IEEE GLOBAL TELECOMMUNICATIONS CONFERENCE. SAN ANTONIO, TX, NOV. 25 - 29, 2001, IEEE GLOBAL TELECOMMUNICATIONS CONFERENCE, NEW YORK, NY : IEEE, US, vol. VOL. 5 OF 6, 25 November 2001 (2001-11-25), pages 3019-3024, XP010747547 ISBN: 0-7803-7206-9 * the whole document * ----- -/-- | 1-10 | TECHNICAL FIELDS SEARCHED (IPC) H03M |

The present search report has been drawn up for all claims

| Place of search | Date of completion of the search | Examiner |
|---|---|---|
| The Hague | 19 April 2007 | Rydyger, Kay |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**European Patent Office**

**EUROPEAN SEARCH REPORT**

Application Number

EP 07 00 1428

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MANSOUR M M: "Unified decoder architectures for repeat-accumulate and LDPC codes" SIGNALS, SYSTEMS AND COMPUTERS, 2004. CONFERENCE RECORD OF THE THIRTY-EIGHTH ASILOMAR CONFERENCE ON PACIFIC GROVE, CA, USA NOV. 7-10, 2004, PISCATAWAY, NJ, USA,IEEE, 7 November 2004 (2004-11-07), pages 527-531, XP010780371 ISBN: 0-7803-8622-1 * the whole document * ----- | 1-10 | |
| A | US 2004/057575 A1 (ZHANG TONG [US] ET AL) 25 March 2004 (2004-03-25) * figure 4 * ----- | 1-10 | |
| A | ZARKESHVARI F ET AL: "On implementation of min-sum algorithm for decoding low-density parity-check (LDPC) codes" GLOBECOM'02. 2002 - IEEE GLOBAL TELECOMMUNICATIONS CONFERENCE. CONFERENCE PROCEEDINGS. TAIPEI, TAIWAN, NOV. 17 - 21, 2002, IEEE GLOBAL TELECOMMUNICATIONS CONFERENCE, NEW YORK, NY : IEEE, US, vol. VOL. 1 OF 3, 17 November 2002 (2002-11-17), pages 1349-1353, XP010636365 ISBN: 0-7803-7632-3 ----- | 1-10 | TECHNICAL FIELDS SEARCHED (IPC) |
| A | TORBEN BRACK, MATTHIAS ALLES, FRANK KIENLE, NORBERT WEHN: "A SYNTHESIZABLE IP CORE FOR WIMAX 802.16E LDPC CODE DECODING" INTERNET ARTICLE, [Online] 2006, XP002430222 Retrieved from the Internet: URL:http://www.eit.uni-kl.de/wehn/files/pu blikationen/2006/PIMRC06.pdf> [retrieved on 2007-04-19] * the whole document * ----- | 1-10 | |

The present search report has been drawn up for all claims

| Place of search | Date of completion of the search | Examiner |
|---|---|---|
| The Hague | 19 April 2007 | Rydyger, Kay |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 00 1428

This annex lists the patent family members relating to the patent documents cited in the above-mentioned European search report.
The members are as contained in the European Patent Office EDP file on
The European Patent Office is in no way liable for these particulars which are merely given for the purpose of information.

19-04-2007

| Patent document cited in search report | Publication date | Patent family member(s) | Publication date |
|---|---|---|---|
| US 2004057575 A1 | 25-03-2004 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ROBERT C. GALLAGHER.** Low-density parity-check codes. The M.I.T. Press, 1963

- **DALE E. HOCEVAR.** A reduced complexity decoder architecture via layered decoding of LDPC codes. *Signal Processing Systems,* 2004